# EUROPÄISCHE PATENTANMELDUNG

(11) **EP 1 918 632 A1**
(43) Veröffentlichungstag der Anmeldung: **07.05.2008**
(21) Anmeldenummer: 06123475.3
(22) Anmeldetag: 03.11.2006
(51) Int. Cl.: F21L 4/00, A61B 17/00, F21Y 101/02

(54) **Leuchtvorrichtung mit wenigstens einer Leuchtdiode**

(71) Anmelder: Asetronics AG, 3018 Bern 18 (CH)
(72) Erfinder: Meister, Bruno, 2540 Grenchen (CH)
(74) Vertreter: Rutz, Peter

(57) **Zusammenfassung**

Die insbesondere für die Verwendung im Medizinalbereich vorgesehene Leuchtvorrichtung weist eine wenigstens eine Leuchtdiode (11) umfassende Leuchteinheit (1) auf, die über elektrische Leitungen (21, 22) mit einer Energieversorgungsvorrichtung (3) verbunden oder verbindbar ist. Erfindungsgemäss ist ein Verbindungselement (2) vorgesehen, das ein streifenförmiges, flexibles und isolierendes Basissubstrat (21) aufweist, das einseitig oder beidseitig mit Metall beschichtet ist, in das die elektrischen Leitungen (22; 23) eingearbeitet sind, die an einem Ende des Verbindungselements (2) zu Anschlüssen (25) der Leuchteinheit (1) und am anderen Ende des Verbindungselements (2) zu Anschlüssen (26) der Energieversorgungsvorrichtung (3) geführt sind, wobei die auf einer oder beiden Seiten des Basissubstrats (21) vorgesehenen Metallschichten (22, 23, 24) derart dimensioniert sind, dass sie das Basissubstrat (21) in einer gewählten Form halten.

## Beschreibung

Die Erfindung betrifft eine insbesondere für die Verwendung im Medizinalbereich vorgesehene Leuchtvorrichtung, die eine mit wenigstens einer Leuchtdiode versehene Leuchteinheit aufweist.

Die Erfindung betrifft insbesondere eine mit wenigstens einer Leuchtdiode versehene Operationsleuchte.

Die Beleuchtung eines Gegenstandes ist normalerweise eine zwingend notwendige Voraussetzung für dessen Bearbeitung oder zumindest für dessen Observierung im Rahmen menschlicher Tätigkeiten und Handlungen.

Dabei sind verschiedene Faktoren zu beachten. Die Leuchtvorrichtung soll kostengünstig sein. Nach Ende der Betriebszeit soll die Leuchtvorrichtung schadlos entsorgt oder sogar rezykliert werden können. Die Leuchtvorrichtung soll insbesondere hinsichtlich der Lagerung und des Transport wenig Platz in Anspruch nehmen. Die Leuchtvorrichtung soll problemlos handhabbar sein. Die Leuchtvorrichtung soll bei Bedarf möglichst sofort zur Verfügung stehen. Insbesondere soll die Leuchtvorrichtung Licht mit genügend hoher Intensität abgeben und den zu bearbeitenden bzw. zu berücksichtigenden Gegenstand gegebenenfalls mit einer gewünschten Farbtemperatur optimal beleuchten.

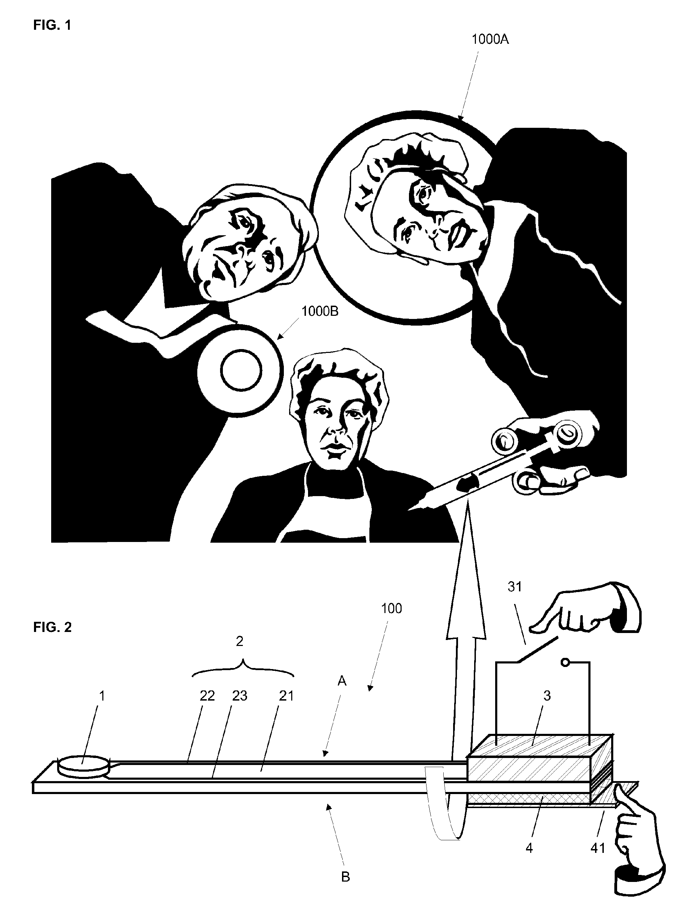

Aus dem Stand der Technik sind zahlreiche Leuchtvorrichtungen bekannt, die jeweils einzelne dieser Forderungen erfüllen. Besonders kritisch ist die Frage der Beleuchtung im Medizinalbereich, in dem Licht nicht nur in genügend hoher Intensität und der erforderlichen Farbtemperatur vorhanden sein muss. Wesentlich in diesem Bereich ist, dass der zu observierende und gegebenenfalls zu bearbeitende Körper beleuchtet wird, ohne dass ein Schattenwurf auftritt oder die Leuchtvorrichtung störend in Erscheinung tritt oder Hilfspersonal erforderlich macht, welches die Leuchtvorrichtung bedient, wie dies nachstehend in Figur 1 illustriert ist. Figur 1 zeigt drei über einen Operationstisch gebeugte medizinische Angestellte, rechts im Bild einen Arzt, in der Mitte eine Chirurgieschwester und links einen Assistenten, aus der Sicht des Patienten. Durch den Arzt wird eine fest installierte Operationsleuchte 1000A teilweise abgedeckt, so dass ein zu behandelnder Körperteil des Patienten nicht mehr genügend beleuchtet ist. Um den durch den Arzt verursachten Schattenwurf zu kompensieren, richtet der Assistent den Strahl einer manuell gehaltenen Lampe auf das zu behandelnde Körperteil und gerät somit störend in den Aktionsradius des Arztes und der Chirurgieschwester, die dem Arzt medizinisches Gerät oder Werkzeug reicht.

In [1], EP 1 568 937 A1 ist eine Operationsleuchte gezeigt, die wenigstens eine Strahlungsquelle und wenigstens zwei Reflektoren aufweist. Zur Bildung eines schattenarmen Beleuchtungsfeldes trifft aus der Operationsleuchte austretende Strahlung mit wenigstens zwei unterschiedlichen Einfallswinkeln auf das Beleuchtungsfeld auf. Dabei sind die Einfallswinkel der Strahlung durch Änderung des Abstandes zwischen wenigstens zwei Reflektoren oder zwischen einem Reflektor und der Strahlungsquelle einstellbar.

Aus [2], US 2003/0185009 A1 ist eine Operationsleuchte mit mehreren Leuchteinheiten bekannt, die in Abhängigkeit der Lichtintensität gesteuert werden, die von einem Sensor an einer Stelle des Arbeitsfeldes erfasst wird, innerhalb dessen Schatteneinwirkungen kompensiert werden sollen. Diese Vorrichtung erfordert ein leistungsfähiges Mess- und Regelsystem und ist daher sehr aufwendig gestaltet.

Der vorliegenden Erfindung liegt daher die Aufgabe zugrunde, eine kostengünstig herstellbare Leuchtvorrichtung zu schaffen, welche nicht mit den oben beschriebenen Nachteilen behaftet ist.

Insbesondere soll die Leuchtvorrichtung Licht mit genügend hoher Intensität abgeben und den zu bearbeitenden bzw. zu observierenden Gegenstand optimal beleuchten.

Ferner soll eine insbesondere im Medizinalbereich vorteilhaft verwendbare Leuchtvorrichtung geschaffen werden, die einfach ausgestaltet sowie einfach zu handhaben ist und mittels der ein Arbeitsfeld ohne Schattenbildung ausgeleuchtet bzw. eine zu behandelnde Körperpartie optimal beleuchtet werden kann.

Die Lösung dieser Aufgabe gelingt mit einer Leuchtvorrichtung gemäss Patentanspruch 1.

Die insbesondere für die Verwendung im Medizinalbereich vorgesehene Leuchtvorrichtung weist eine wenigstens eine Leuchtdiode umfassende Leuchteinheit auf, die über elektrische Leitungen mit einer Energieversorgungsvorrichtung verbunden oder verbindbar ist. Erfindungsgemäss ist ein Verbindungselement vorgesehen, das ein streifenförmiges, flexibles und isolierendes Basissubstrat aufweist, das einseitig oder beidseitig mit Metall beschichtet ist, in das die elektrischen Leitungen eingearbeitet sind, die an einem Ende des Verbindungselements zu Anschlüssen der Leuchteinheit und am anderen Ende des Verbindungselements zu Anschlüssen der Energieversorgungsvorrichtung geführt sind, wobei die auf einer oder beiden Seiten des Basissubstrats vorgesehene Metallschicht bzw. Metallschichten derart dimensioniert sind, dass sie das Basissubstrat in einer vom Anwender jeweils bedarfsweise gewählten Form halten.

Das Verbindungselement ist dabei vorzugsweise ein mittels Leiterplattentechnik, insbesondere Additiv-Technik und/oder Subtraktiv-Technik gefertigtes flexibles Leiterplattenelement.

Die erfindungsgemässe Leuchtvorrichtung erfüllt in Kombination die für den Anwender wesentlichen Anforderungen, die eingangs geschildert wurden. Ein wesentliches Element der Leuchtvorrichtung ist das Verbindungselement, welches mechanische, elektrische und gegebenenfalls sogar thermische Funktionen erfüllt. Einerseits dient das Verbindungselement der Stromzufuhr. Andererseits kann das Verbindungselement beliebig geformt werden, um das Licht in eine gewünschte Richtung zu lenken oder auszurichten. Ferner dient das Verbindungselement 2 vorzugsweise der Aufnahme der von der Leuchteinheit abgegebenen Wärmeenergie.

Aufgrund der Fertigung des Verbindungselements mittels Leiterplattentechnik kann die Leuchtvorrichtung daher nicht nur kostengünstig hergestellt werden, sondern es ist möglich die Eigenschaften des als beweglicher Leuchtenarm dienenden Verbindungselements mit einfachsten Massnahmen beliebig festzulegen.

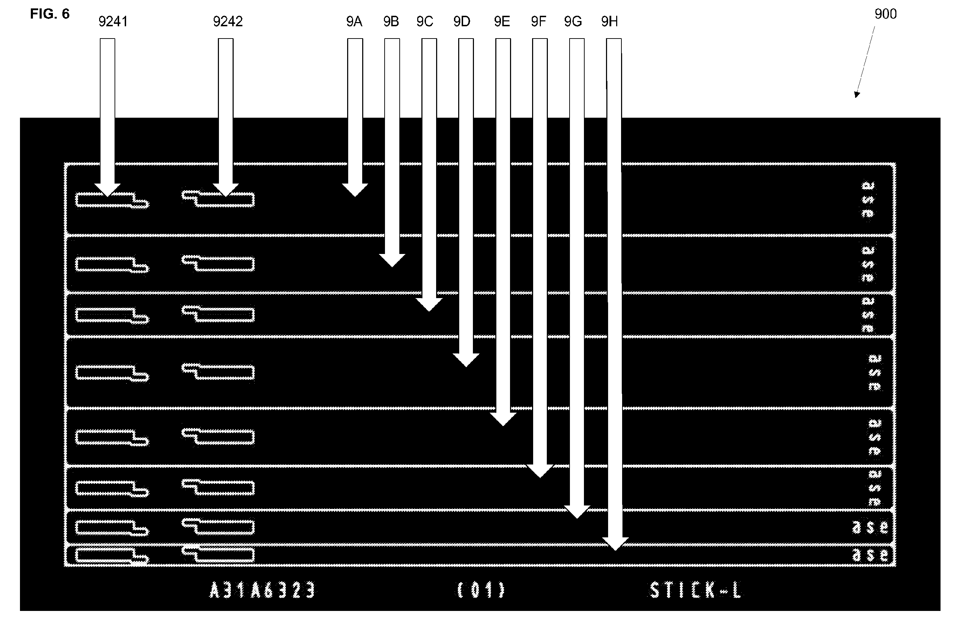

Mittels Leiterplattentechnik, die dem Fachmann aus [3], Handbuch der Leiterplattentechnik, 2. Auflage, Leuze Verlag, D-7968 SAULGAU/WÜRTT, 1982 bekannt ist, können daher beliebige Leuchtenarme bzw. Verbindungselemente gefertigt werden. Die Verbindungselemente können im Nutzen (siehe die Fertigungsmaske in Figur 6) in hoher Stückzahl mit beliebigen Dimensionen, Längen und Breiten, und mit beliebigen fachmännisch verwendbaren Metallen in den erforderlichen Dicken gefertigt werden.

Das Basissubstrat ist vorzugsweise auf beiden Seiten mit einer Metallschicht vorzugsweise aus Kupfer oder einer geeigneten Legierung versehen, wobei die elektrischen Leitungen nur auf einer oder vereinzelt je auf einer Seite des Basissubstrats angeordnet sind. Sofern die Leiterbahnen nur auf einer Seite angeordnet sind, kann die vorzugsweise auf der anderen Seite des Basissubstrats angeordnete Metallschicht als Schutzschicht, als Stabilisationsschicht oder als Wärmesenke (Heat Sink) vorgesehen und verwendet werden. Dabei wird, gegebenenfalls mittels thermisch leitender Elemente, die in der Leuchteinheit integriert oder aufgetragen werden können, ein möglichst guter Wärmetransfer von der Leuchteinheit zum Verbindungselement realisiert. Dadurch können leistungsstärkere Leuchtdiodenanordnungen verwendet und Ausfälle aufgrund thermischer Probleme vermieden werden.

Vorzugsweise werden ein- oder beidseitig beschichtete Basissubstrate verwendet, deren Metallschichten durch subtraktive Verfahren bearbeitet werden. Alternativ und oder kumulativ sind additive Verfahren anwendbar, bei denen die gewünschten Metallschichten additiv aufgetragen werden. Siehe diesbezüglich in [3], Seite 25 und Seite 49 ff.

Beispielsweise wird ein kupferkaschiertes Basissubstrat vom Typ FR-2, FR-3, oder FR-4 verwendet, das vorzugsweise aus Reaktionsharz; Phenol oder Epoxid; Verstärkungsmaterial; sowie Papier oder Glasgewebe oder einer geeigneten Kombination davon besteht. Vorteilhaft verwendbar sind ferner Basismaterialien bzw. Basismaterialien für flexible Schaltungen, wie Epoxidharz-Glashartgewebelaminate, Polyesterfolien, Plymidfolien, Teflonfolien oder Kombinationen davon (siehe [3], Seiten 51 und 52).

Beispielsweise wird ein Basissubstrat mit einer Dicke von etwa 0,05 mm bis 0,15 mm verwendet, dass auf einer oder beiden Seiten mit Metallschichten versehen ist, deren Dicken um den Faktor 1,5 - 10 mal grösser gewählt sind, als die Dicke des Basissubstrats.

Da das Verbindungselement mittels Leiterplattentechnik gefertigt wird, kann die Leuchteinheit, die wenigstens eine Leuchtdiode, wenigstens einen SMD-LED-Baustein oder wenigstens einen "nackten" gebondeten LED-Chip umfasst, in einfacher Weise in einem zusätzlichen Verfahrensschritt innerhalb von Sekunden mechanisch und elektrisch fest mit den Leiterbahnen verbunden werden.

Aufgrund der verwendeten Technologien kann die Leuchtvorrichtung kompakt und in hohen Dichten gefertigt und gelagert werden. Die Fertigung kann in sterilen Räumen erfolgen, so dass die vorzugsweise mit lösbaren Schutzfolien versehenen Leuchtvorrichtungen in der erforderlichen Reinheit in Operationssälen eingesetzt werden können. Alternativ können die Leuchtvorrichtungen nach Abschluss der Fertigung und vor der Verpackung sterilisiert werden.

Besonders wesentlich ist zudem, dass die erfindungsgemässe Leuchtvorrichtung mittels Leiterplattentechnik mit minimalem Gewicht gefertigt werden kann. Die Leuchtvorrichtung kann daher an dem der Leuchteinheit entgegen gesetzten Ende des Verbindungselements vorteilhaft mit einem Montageelement versehen werden, welches mit dem Verbindungselement oder mit der Energieversorgungsvorrichtung verbunden wird. In dieser Ausgestaltung kann die Leuchtvorrichtung daher an beliebigen passenden Stellen montiert werden.

Beispielsweise ist das Montageelement
a) ein flächiges, beidseitig mit Haftstoff versehenes Haftelement, dessen eine Seite am Verbindungselement oder an der Energieversorgungsvorrichtung haftet und dessen andere Seite mit einer lösbaren Schutzfolie abgedeckt ist;
b) wenigstens ein Magnetelement; oder
c) ein mechanisches Klemm- oder Klammerelement, das gegebenenfalls einstückig mit dem Gehäuse der Energieversorgungsvorrichtung verbunden ist.

Die Verwendung eines Haftelements, beispielsweise eines Stücks eines doppelseitigen Klebbandes, ist dabei besonders vorteilhaft, da dieses während der Fertigung der Leuchtvorrichtung einseitig mit dem Verbindungselement oder der Energieversorgungsvorrichtung verbunden und bei Gebrauch, beispielsweise in einem Operationssaal, nach dem Lösen der Schutzfolie an ein Hilfsmittel, beispielsweise ein Operationswerkzeug oder an der Brille des Anwenders befestigt werden kann.

In vielen Bereichen kann die Verwendung eines vorzugsweise hartmagnetischen Montageelements vorteilhaft sein. Beispielsweise während einer Bahnfahrt kann der Anwender das magnetische Montageelement an einem Vorrichtungsteil des Eisenbahnwagens wie einem Metallrahmen oder Metallträger befestigen und ausrichten, so dass der Sitzplatz bzw. das Blickfeld optimal ausgeleuchtet ist.

Ganz besonders vorteilhaft ist auch die Verwendung eines Klemm- oder Klammerelements, das beispielsweise auf den Deckel eines Buches geklemmt wird. Das Verbindungselement mit der Leuchteinheit bzw. der Leuchtenarm kann anschliessend über die Buchseiten gebogen werden, so dass diese optimal beleuchtet wird. Das Gehäuse der Energieversorgungsvorrichtung kann dabei eine Öffnung oder einen Schacht zur Aufnahme des Endstücks des Verbindungselements aufweisen, das bei Bedarf eingesetzt und anschliessend als Lesezeichen zwischen die Buchseiten geklemmt und dadurch elegant versorgt werden kann. Beim Einschieben des Verbindungselements resultiert dabei vorzugsweise automatisch ein elektrischer Kontakt, so dass sich ein Schalter erübrigt.

Schaltmittel oder gar ein zur Betätigung einer optionalen Steuereinheit dienender Funktionsschalter können bei in jeder Ausgestaltung der Vorrichtung vorgesehen werden. Ferner ist es möglich, zusätzliche Leiterbahnen über das Verbindungselement zu ziehen, so dass einzelne Elemente der Leuchteinheit individuell betätigt werden können. Beispielsweise umfasst die Leuchteinheit unterschiedliche Leuchtelemente, gegebenenfalls Leuchtdioden unterschiedlicher Farbabstrahlung, Leistungsaufnahme oder Abstrahlcharakteristik, die individuell ansteuerbar und betätigbar sind.

Die Energieversorgungsvorrichtung weist vorzugsweise ein Gehäuse aus Kunststoff auf, in dem eine Energiequelle, beispielsweise wenigstens eine Batterie oder ein Akkumulator, fest oder auswechselbar montiert ist. Die Energiequelle ist gegebenenfalls via Kontakte und Schaltmittel mit den Anschlüssen der Leiterbahnen verbindbar oder fest verbunden ist. Ferner ist es vorteilhaft möglich, die Schaltmittel innerhalb des Verbindungselements anzuordnen. Beispielsweise kann während der Fertigung ein Wippschalter auf das Verbindungselement aufgesetzt werden, mittels dessen Segmente einer Leiterbahn wahlweise miteinander verbindbar sind.

Zum Schutz oder zur grafischen Gestaltung wird die Leuchtvorrichtung vorzugsweise ganz oder teilweise mit einer vorzugsweise transparenten Lage, gegebenenfalls aus Kunststoff, beschichtet. Dabei können erfindungsgemässe Leuchtvorrichtungen, zumindest die mit Leuchteinheiten und/oder Schaltmitteln bestückten Verbindungselemente, im Nutzen gefertigt, gegebenenfalls ausgeliefert und erst anwenderseitig mit der Energieversorgungsvorrichtung verbunden werden.

Die werks- oder anwenderseitige Verbindung der Energieversorgungsvorrichtung, beispielsweise ein einfacher Batteriekasten, kann auf verschiedene Arten erfolgen. Beispielsweise werden Kontakte der Energieversorgungsvorrichtung und Kontakte des Verbindungselements miteinander verlötet. Alternativ sind Steckverbindungen oder Klemmverbindungen verwendbar, welche die entspürechenden Kontakte gegeneinander drücken und fixieren. Ferner kann das Gehäuse der Energieversorgungsvorrichtung mit Klebstoff, Flanschen oder dem oben erwähnten Schacht versehen sein, mittels derer das Verbindungselement fest oder lösbar gehalten wird.

Die Leuchtvorrichtung nimmt wenig Platz in Anspruch und kann insbesondere auch wegen des geringen Gewichts problemlos gehandhabt werden. Aufgrund der geringen Abmessungen und gegebenenfalls der Lieferung im Nutzen kann dieses überall bereitgehalten werden und steht bei Bedarf sofort zur Verfügung. Nach Ende der Betriebszeit kann die Leuchtvorrichtung nicht nur schadlos entsorgt, sondern sogar vorteilhaft rezykliert werden, da die Metallschichten problemlos abgelöst und zurück gewonnen und für die Produktion neuer Leuchtvorrichtungen verwendet werden können.

Die Erfindung wird nachstehend anhand von Zeichnungen näher erläutert. Dabei zeigt:
- Fig. 1: medizinische Angestellte in einem Operationssaal und sich ergänzende Mittel 1000A, 1000B zur Beleuchtung eines Arbeitsfeldes;
- Fig. 2: eine erfindungsgemässe Leuchtvorrichtung 100 mit einem aus einem Basissubstrat 21, und zwei elektrischen Leitungen 22, 23 bestehenden, mittel Leiterplattentechnik gefertigten Verbindungselement 2, welches an einem Ende, an der Oberseite A, eine Leuchteinheit 1 und am anderen Ende, an der Oberseite A, eine mittels Schaltmitteln 31 betätigbare Energieversorgungsvorrichtung 3 und an der Unterseite B ein Montageelement 4 aufweist;
- Fig. 3a: vier von einer Assistentin präsentierte Leuchtvorrichtungen 100, die lösbar voneinander in einem Array gefertigt und geliefert wurden;
- Fig. 3b: eine erfindungsgemässe Leuchtvorrichtung 100, die mittels des Montageelements 4, wie einem Haftelement oder einem Klammerelement, an einer von ein Ärztin getragenen Brille befestigt ist;
- Fig. 4: eine erfindungsgemässe Leuchtvorrichtung 100, in einer weiteren vorzugsweisen Ausgestaltung, mit der Energieversorgungsvorrichtung 3 an der Unterseite B des Verbindungselements 2 montiert, auf dem mittels Leiterplattentechnik und Bestückungsautomaten ein Schaltelement 31 angeordnet ist;
- Fig. 5: in einer Explosionsdarstellung die Leuchtvorrichtung 100 von Figur 4 mit einer vorzugsweise ausgestalteten Energieversorgungs-vorrichtung 3, deren vorzugsweise aus Kunststoff gefertigtes Gehäuse 35 ein einstückig angeformtes Klammerelement 351 aufweist,
- Fig.6: eine Maske für die Fertigung von unterschiedlich dimensionierten Verbindungselementen 2 mittels Leiterplattentechnik im Nutzen;

- Fig. 7: eine erfindungsgemässe Leuchtvorrichtung 100 mit einer mittels Hartmagneten 38S, 38N montierten Energieversorgungsvorrichtung 3;
- Fig. 8: weitere mögliche Anwender der erfindungsgemässen Leuchtvorrichtung 100;
- Fig. 9: eine erfindungsgemässe Leuchtvorrichtung 100 mit der Leuchteinheit 1 auf der Oberseite A und der Energieversorgungsvorrichtung 3, an der das Montageelement 4 anhaftet, auf der Unterseite B des Verbindungselements 2; und
- Fig. 10: eine erfindungsgemässe Leuchtvorrichtung 100 mit einer Energieversorgungsvorrichtung 3, dessen Gehäuse 35 einen der Aufnahme des Verbindungselements 2 dienenden Schacht 351 und ein angehaftetes oder, in einer alternativ gezeigten Ausgestaltung (siehe Fig. 10a), ein angeformtes Montageelement 4, 352 aufweist.

Figur 1 zeigt medizinische Angestellte in einem Operationssaal und sich ergänzende Mittel 1000A, 1000B zur Beleuchtung eines Arbeitsfeldes. Durch den Arzt wird eine fest installierte Operationsleuchte 1000A teilweise abgedeckt, so dass der zu behandelnde Körperteil eines Patienten nicht mehr genügend beleuchtet ist. Um den durch den Arzt verursachten Schattenwurf zu kompensieren, richtet der Assistent den Strahl einer manuell gehaltenen Lampe auf das zu behandelnde Körperteil und gerät somit störend in den Aktionsradius des Arztes und der Chirurgieschwester, die dem Arzt medizinisches Gerät oder Werkzeug reicht. Probleme dieser Art lassen sich mittels der erfindungsgemässen Leuchtvorrichtung 100 von Figur 2 vorteilhaft vermeiden.

Fig. 2 zeigt eine erfindungsgemässe Leuchtvorrichtung 100, in einer ersten Ausgestaltung, mit einem aus einem Basissubstrat 21, und zwei elektrischen Leitungen 22, 23 bestehenden, mittel Leiterplattentechnik gefertigten Verbindungselement 2, welches an der Oberseite A an einem Ende, eine Leuchteinheit 1 und am anderen Ende eine Energieversorgungsvorrichtung 3 aufweist, die mittels schematisch gezeigten Schaltmitteln 31 mit den elektrischen Leitungen 22, 23 verbindbar ist, um die die Leuchteinheit 1 mit Strom zu versorgen. An der Unterseite B des Verbindungselements 2 ist ein Montageelement 4 vorgesehen, mittels der die Leuchtvorrichtung 100 an einem gewünschten Objekt montierbar ist.

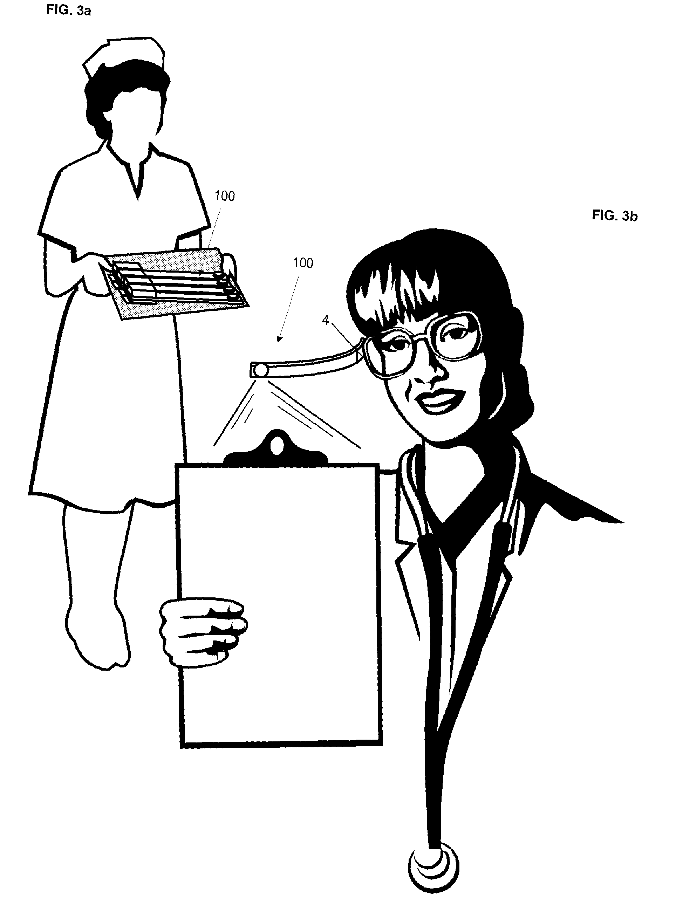

Figur 3a zeigt vier von einer Assistentin präsentierte Leuchtvorrichtungen 100 gemäss Figur 2, die lösbar voneinander in einem Array gefertigt und geliefert wurden.

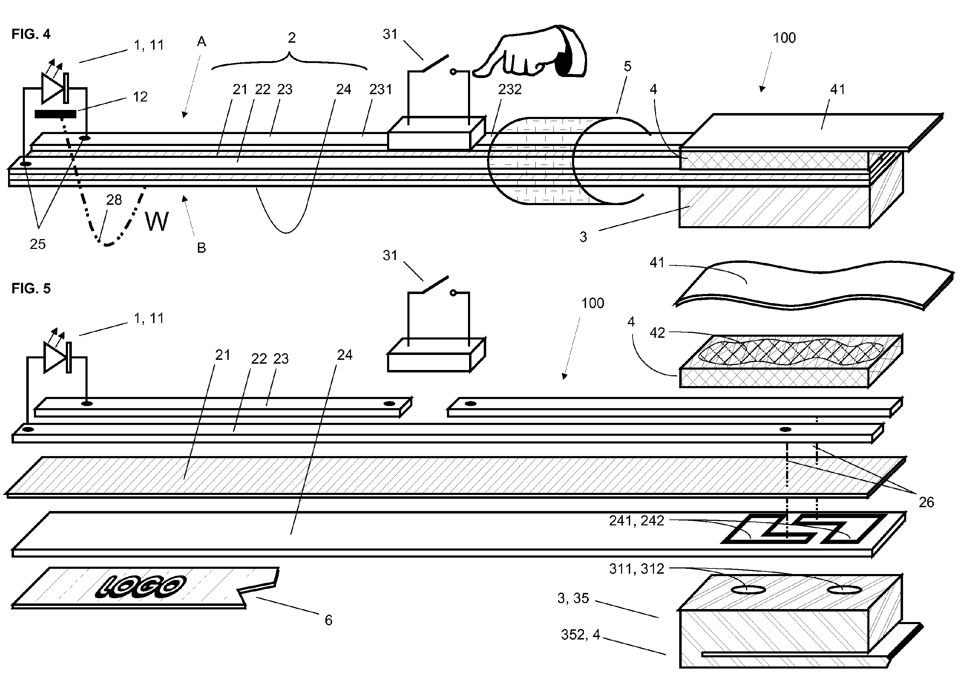

Figur 3b zeigt eine erfindungsgemässe Leuchtvorrichtung 100 gemäss Figur 4, die mittels eines haftenden Montageelements 4 an einer von einer Ärztin getragenen Brille befestigt ist.

Figur 4 zeigt in einer weiteren vorzugsweisen Ausgestaltung eine erfindungsgemässe Leuchtvorrichtung 100 mit der Leuchteinheit 1 und dem Montageelement 4 an der Oberseite A und der Energieversorgungsvorrichtung 3 an der Unterseite B des Verbindungselements 2 montiert. Auf diese Weise sind die Leuchteinheit 1 und das Montageelement 4 auf dieselbe Seite gerichtet, was bei der in Figur 3b gezeigten Verwendung von Vorteil ist, da des Verbindungselement 2 nur geringfügig gebogen werden muss, um das Blickfeld zu beleuchten.

Figur 5 zeigt die Leuchtvorrichtung 100 von Figur 4 in einer Explosionsdarstellung.

Die Leuchtvorrichtung 100 von Figur 4 weist ein Verbindungselement 2 mit einem Basissubstrat 21 auf, das beidseitig mittels Leiterplattentechnik bearbeitete Metallschichten 22, 23 (bzw. 231 und 232), 24 vorzugsweise aus Kupfer aufweist, die der Stabilisierung des Basissubstrats 21 in einer gewünschten Form, der Leitung elektrischen Stroms zur Leuchteinheit 1 und vorzugsweise zur Aufnahme der von der Leuchteinheit 1 abgegebenen Wärme dienen. Die nach Ätzprozessen verbliebenen Metallschichten 22, 23 (bzw. 231 und 232) auf der Oberseite A des Verbindungselements 2 dienen der Leitung des elektrischen Stroms. Die Leitung 23 ist in die Segmente 231 und 232 getrennt, die mittels eines vorzugsweise mittels eines Bestückungsautomaten aufgesetzten und gebondeten Schalters 31 wahlweise verbindbar sind.

Beispielsweise wird ein Basissubstrat 21 mit einer Dicke von etwa 0,05 mm bis 0,15 mm verwendet, dass auf einer oder beiden Seiten mit Metallschichten 22, 23, 24 versehen ist, deren Dicken um den Faktor 1,5 - 10 mal grösser gewählt sind, als die Dicke des Basissubstrats 21. Möglich ist auch die Wahl unterschiedlicher Dicken. Sofern die auf der Unterseite B vorgesehene Metallschicht der Wärmeaufnahme dient, kann diese Schicht dicker ausgestaltet sein und dadurch auch dominant die Tragfunktion wahrnehmen. In Figur 4 ist gezeigt, dass ein Wärmekontakt 12 der Leuchteinheit 1 mittels einer thermischen Verbindung 28 mit der an der Unterseite B des Verbindungselements 2 vorgesehenen Metallschicht 24 verbunden ist. Elektrisch ist die schematisch dargestellte Leuchteinheit 1 via Kontakte 25 mit den elektrischen Leitungen 22, 23 verbunden.

Da das Verbindungselement 2 mittels Leiterplattentechnik gefertigt wird, kann die Leuchteinheit 1, die wenigstens eine Leuchtdiode 11, wenigstens einen SMD-LED-Baustein oder wenigstens einen "nackten" gebondeten LED-Chip umfasst, ebenso wie der Schalter 31 oder eine Steuereinheit 310 (siehe Figur 19) in einfacher Weise in einem zusätzlichen Verfahrensschritt innerhalb von Sekunden mechanisch und elektrisch fest mit den Leiterbahnen 22, 23 verbunden werden.

Als Leuchteinheiten 1 sind beispielsweise Produkte von Osram verwendbar, die unter den Zeichen TOPLED®; Power TOPLED®, Advanced Power TOPLED®, Golden DRAGON®, Platinum DRAGON®, OSTAR®, MULTILED®, Mini TOPLED®, PointLED®, SmartLED® 0603, CHIPLED, SIDELED®, Micro SIDELED®, und FIREFLY® vermarktet werden. Aus diesen oder äquivalenten Produkten, die vorzugsweise ohne Gehäuse verwendet werden, weisen individuell für jeden Verwendungsbereich vorteilhafte Eigenschaften, wie Lichtintensität, Abstrahlwinkel, und Farbtemperatur, auf.

In den Figuren 4 und 5 ist ferner gezeigt, dass die Leuchtvorrichtung 100 mit wenigstens einer gegebenenfalls grafisch gestalteten, isolierenden und vorzugsweise transparenten Schutzschicht 6 versehen sein kann. Ferner kann eine Schutzhülle 5 vorgesehen sein, welche verhindert, dass die vorzugsweise steril gefertigte oder sterilisierte Leuchtvorrichtung 100 kontaminiert wird.

In den Figuren 4 und 5 sind ferner vorzugsweise Ausgestaltungen der Energieversorgungsvorrichtung 3 und des Montageelements 4 gezeigt. In Figur 4 ist das Montageelement 4 ein zweiseitig mit Haftmittel oder Klebstoff 42 beschichtetes Haftelement, das mit einer Seite am Verbindungselement 2 haftet und an der anderen Seite ein Schutzfolie 41 trägt, die entfernt wird, sobald das Montageelement 4 an einem Objekt, beispielsweise einem Operationswerkzeug befestigt werden soll. Auf diese Weise kann die Leuchteinheit 1 unmittelbar in den Arbeitsbereich, gegebenenfalls sogar in ein geöffnetes Körperteil eines Patienten hinein geführt werden und gibt somit dem Operierenden eine optimale Sicht. In den Figuren 1 und 2 ist schematisch gezeigt, dass die erfindungsgemässe Leuchtvorrichtung 100 mit einer Spritze verbunden und hin zum Körperteil des Patienten werden kann. Die Montageelemente 4 können dabei in der erforderlichen Weise an Werkzeuge aller Art (wie Spritzen, Skalpell, Zangen, vorzugsweise der Fixierung einer geöffneten Wunde dienende Klammern, etc.) angepasst werden. Dabei können die Montageelemente 4 als Haftelemente, Magnete, oder Klammern oder Klemmen ausgebildet sein.

In Figur 5 ist eine Energieversorgungsvorrichtung 3 gezeigt, an deren Gehäuse 35 eine Klammer 352 einstückig angeformt ist. Die Montageelemente 4 können dabei auch in Kombination verwendet werden, wie dies in Figur 5 gezeigt ist.

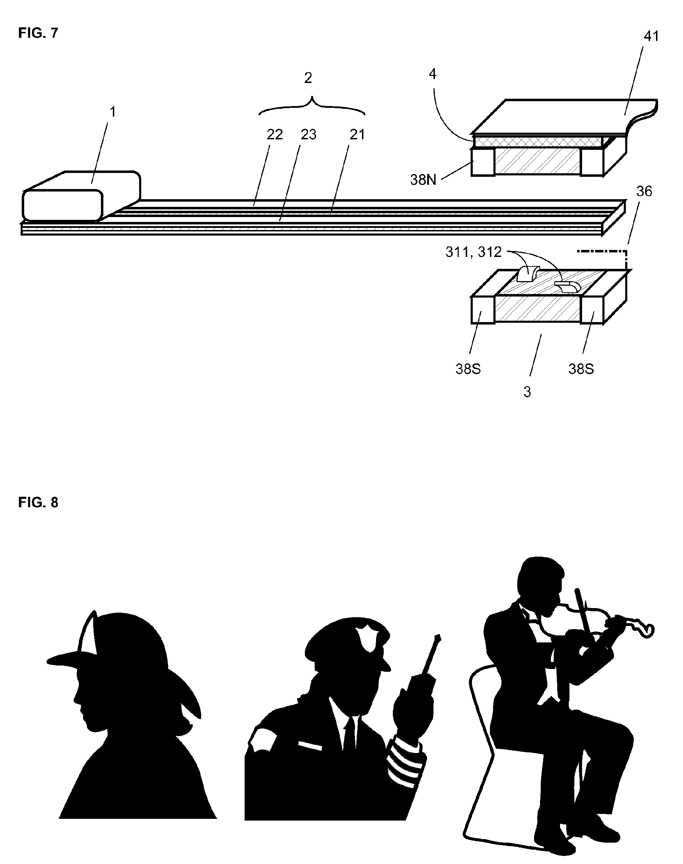

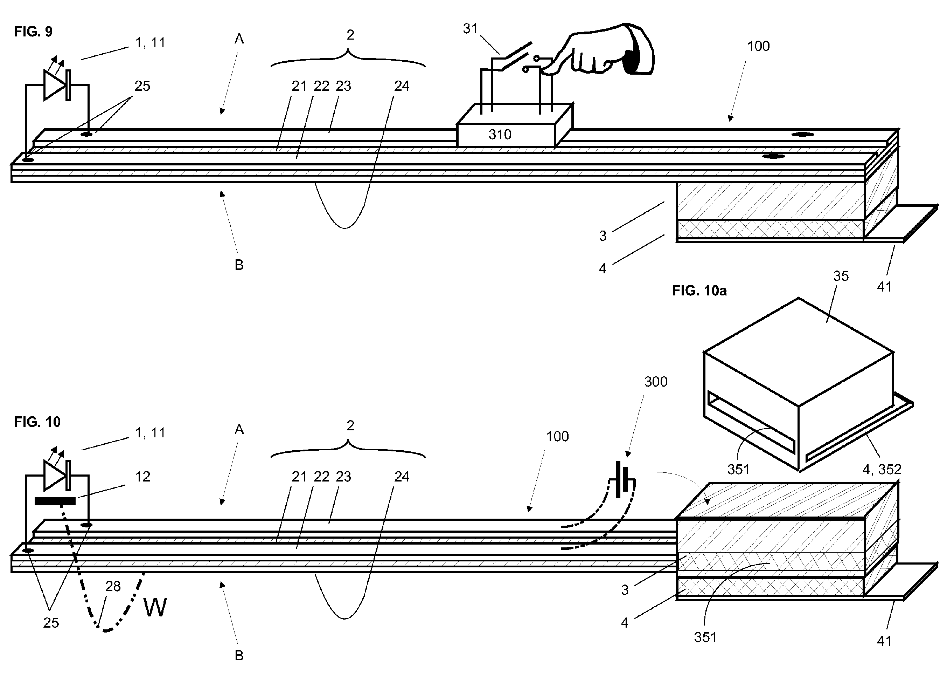

Die elektrische Verbindung der Energieversorgungsvorrichtung 3, die Batterien oder aufladbare Akkumulatoren enthalten kann, mit den elektrischen Leitungen 22, 23 erfolgt bei dieser Ausgestaltung der Erfindung über Kontakte 311, 312, isolierte Kontakte 241, 242 innerhalb der unteren Metallschicht 24 sowie Durchkontaktierungen 26. Die elektrische Verbindung kann fest oder lösbar sein. Sofern das Verbindungselement 2 in einen Schacht 351 des Gehäuses 35 eingeschoben werden kann (siehe Figur 10), so erfolgt der elektrische Kontakt vorzugsweise mittels elastischer Klemmen 311, 312 (siehe Figur 7), welche das eingeschobene Verbindungselement 2 vorzugsweise auch mechanisch fixieren, was aufgrund des geringen Gewichts des Verbindungselements 2 leicht möglich ist. Das geringe Gewicht des Verbindungselements 2 erfordert zudem nur eine geringe Tragkraft des Montageelements 4.

Figur 6 zeigt eine Maske 900 für die Fertigung von unterschiedlich dimensionierten Verbindungselementen 2 mittels Leiterplattentechnik. Verschiedenartige Verbindungselemente 2, für die Maskensegmente 9A, ..., 9H vorgesehen sind, können im Nutzen gefertigt und mit Leuchteinheiten 1 und gegebenenfalls Schaltern 31 bestückt werden. Die in Figur 6 gezeigte Maske 900 dient der Fertigung der in Figur 5 gezeigten unteren Metallschicht 24. Die Maskenelemente 9241, 9242 dienen der Fertigung der isolierten Kontakte 241, 242 innerhalb der unteren Metallschicht 24.

Fig. 7 zeigt eine erfindungsgemässe Leuchtvorrichtung 100 mit einer mittels Hartmagneten 38S, 38N montierten Energieversorgungsvorrichtung 3. Die Energieversorgungsvorrichtung 3 besteht aus zwei beispielsweise gelenkig miteinander verbundenen Teilen, die das Verbindungselement 2 beidseitig einschliessen und fest halten können, was bereits mit kleineren Hartmagneten problemlos realisierbar ist. Hartmagnetische Werkstoffe sind beispielsweise Kobalt-Samarium (SmCo5, Sm2Co17, Sm(Co, Cu, Fe, Zr) und Neodym-Eisen-Bor (NdFeB). Durch die Andruckkraft der Hartmagnete kann gleichzeitig der Kontakt zwischen den Leiterbahnen 22, 23 und den elektrischen Kontakten 311, 312 der Energieversorgungsvorrichtung 3 erstellt und gesichert werden. Fernern können die Hartmagnete 38S, 38N gleichzeitig als Montageelemente 4 dienen, die optional in Kombination mit anderen Montageelement 4 verwendbar sind.

Figur 8 zeigt weitere mögliche Anwender der erfindungsgemässen Leuchtvorrichtung 100. Insbesondere für Beamte oder Handwerker, die auch in der Nacht ihren Dienst erfüllen, ist die erfindungsgemässe Leuchtvorrichtung 100 besonders dienlich. Ferner ist hochwertige, gegebenenfalls künstlerische Arbeit oft in Räumen zu erbringen, die hinsichtlich dieser Tätigkeiten unvorteilhaft beleuchtet sind. Beispielsweise sollen die Musiker in der Oper durch die Besucher lediglich akustisch wahrgenommen werden, weshalb die Musiker oft nicht über die gewünschten Lichtquellen verfügen. Die erfindungsgemässen Leuchtvorrichtungen 100, deren Licht präzise auf das Notenblatt eines Musikers ausgerichtet werden kann, sind daher auch in diesen Bereich vorteilhaft verwendbar.

Figur 9 zeigt eine erfindungsgemässe Leuchtvorrichtung 100 mit der Leuchteinheit 1 auf der Oberseite A und der Energieversorgungsvorrichtung 3, an der das Montageelement 4 anhaftet, auf der Unterseite B des Verbindungselements 2.

Fig. 10 zeigt eine erfindungsgemässe Leuchtvorrichtung 100 mit einer Energieversorgungsvorrichtung 3, deren Gehäuse 35 einen der Aufnahme des Verbindungselements 2 dienenden Schacht 351 und ein angehaftetes oder, in einer alternativ gezeigten Ausgestaltung (siehe Fig. 10a), ein angeformtes Montageelement 4, 352 aufweist.

Die erfindungsgemässe KLeuchtvorrichtung 100 wurde in bevorzugten Ausgestaltungen beschrieben und dargestellt. Anhand der erfindungsgemässen Lehre sind jedoch weitere fachmännische Ausgestaltungen realisierbar. Insbesondere sind beliebige bekannte Leiteplattentechniken und entsprechende Materialen, beliebige Energiequellen, beliebige LED-Einheiten oder auch weitere Montageelemente anwendbar bzw. einsetzbar.

Die Abgabe des Lichts kann ferner mittels einer gegebenenfalls programmierbaren Steuerung 310 erfolgen, die af das Verbindungselement 2 aufgesetzt oder in die Energieversorgungsvorrichtung 3 integriert ist.

Literaturverzeichnis
[1] EP 1 568 937 A1
[2] US 2003/0185009 A1
[3] Handbuch der Leiterplattentechnik, 2. Auflage, Leuze Verlag, D-7968 SAULGAU/WÜRTT, 1982

## Patentansprüche

1. Leuchtvorrichtung (100), insbesondere für die Verwendung im Medizinalbereich, mit einer wenigstens eine Leuchtdiode (11) umfassenden Leuchteinheit (1), die über elektrische Leitungen (21, 22) mit einer Energieversorgungsvorrichtung (3) verbunden oder verbindbar ist, **dadurch gekennzeichnet, dass** ein Verbindungselement (2) vorgesehen ist, das ein streifenförmiges, flexibles und isolierendes Basissubstrat (21) aufweist, das einseitig oder beidseitig mit Metall beschichtet ist, in das die elektrischen Leitungen (22; 23) eingearbeitet sind, die an einem Ende des Verbindungselements (2) zu Anschlüssen (25) der Leuchteinheit (1) und am anderen Ende des Verbindungselements (2) zu Anschlüssen (26) der Energieversorgungsvorrichtung (3) geführt sind, wobei die auf einer oder beiden Seiten des Basissubstrats (21) vorgesehenen Metallschichten (22, 23, 24) derart dimensioniert sind, dass sie das Basissubstrat (21) in einer gewählten Form halten.

2. Leuchtvorrichtung (100) nach Anspruch 1, **dadurch gekennzeichnet, dass** das Verbindungselement (2) an der Seite, an der die Energieversorgungsvorrichtung (3) vorgesehen ist, ein Montageelement (4) aufweist, welches mit dem Verbindungselement (2) oder mit der Energieversorgungsvorrichtung (3) verbunden ist.

3. Leuchtvorrichtung (100) nach Anspruch 2, **dadurch gekennzeichnet, dass** das Montageelement (4)
a) ein flächiges, beidseitig mit Haftstoff (42) versehenes Haftelement ist, dessen eine Seite am Verbindungselement (2) oder an der Energieversorgungsvorrichtung (3) haftet und dessen andere Seite mit einer lösbaren Schutzfolie (41) abgedeckt ist;
b) wenigstens ein Magnetelement (38S, 38N) ist; oder
c) ein mechanisches Klemm- oder Klammerelement (351) ist, das gegebenenfalls einstückig mit dem Gehäuse (35) verbunden ist.

4. Leuchtvorrichtung (100) nach Anspruch 1, 2 oder 3, **dadurch gekennzeichnet, dass** das Verbindungselement (2) ein mittels Additiv-Technik und/oder Subtraktiv-Technik gefertigtes flexibles Leiterplattenelement ist.

5. Leuchtvorrichtung (100) nach Anspruch 4, **dadurch gekennzeichnet, dass** das Basissubstrat (21) auf beiden Seiten mit einer Metallschicht (22, 23; 24) vorzugsweise aus Kupfer versehen ist, wobei die elektrischen Leitungen (22; 23) nur auf einer oder vereinzelt je auf einer Seite des Basissubstrats (21) angeordnet sind.

6. Leuchtvorrichtung (100) nach Anspruch 4 oder 5, **dadurch gekennzeichnet, dass** das Basissubstrat (21) kupferkaschiert und/oder vom Typ FR-2, FR-3, oder FR-4, ist, und/oder aus Reaktionsharz; Phenol oder Epoxid; Verstärkungsmaterial; Papier oder Glasgewebe, Epoxidharz-Glashartgewebelaminaten, Polyesterfolien, Plymidfolien, Teflonfolien oder Kombinationen besteht.

7. Leuchtvorrichtung (100) nach Anspruch 4, 5 oder 6, **dadurch gekennzeichnet, dass** das Basissubstrat (21) eine Dicke von etwa 0,05 mm bis 0,15 mm aufweist und dass die Dicke der Metallschicht auf einer oder beiden Seiten des Basissubstrats (21) etwa um den Faktor 1,5 - 5 mal grösser ist.

8. Leuchtvorrichtung (100) nach einem der Ansprüche 1 bis 7, **dadurch gekennzeichnet, dass** die Energieversorgungsvorrichtung (3) und die Leuchteinheit (1) auf derselben Seite (A bzw. B) oder auf den einander gegenüberliegenden Seiten (A und B) des Verbindungselements (2) angeordnet sind.

9. Leuchtvorrichtung (100) nach einem der Ansprüche 1 bis 7, **dadurch gekennzeichnet, dass** die mit den Leiterbahnen (22, 23) mechanisch und elektrisch fest verbundene Leuchteinheit (1) wenigstens eine Leuchtdiode (11), wenigstens einen SMD-LED-Baustein oder wenigstens eine "nackten" gebondeten LED-Chip umfasst und/oder dass die Leuchteinheit (1) unterschiedliche Leuchtelemente umfasst, gegebenenfalls Leuchtdioden unterschiedlicher Farbabstrahlung, Leistungsaufnahme und Abstrahlcharakteristik, die individuell ansteuerbar und betätigbar sind.

10. Leuchtvorrichtung (100) nach einem der Ansprüche 1 bis 8, **dadurch gekennzeichnet, dass** die Energieversorgungsvorrichtung (3) ein Gehäuse (35) vorzugsweise aus Kunststoff mit einer darin integrierten oder einsetzbaren Energiequelle (300), wie Batterien, aufweist, die über Kontakte (311, 312) mit den Anschlüssen (26, 241, 242) der Leiterbahnen (22, 23) verbindbar oder fest verbunden ist.

11. Leuchtvorrichtung (100) nach Anspruch 10, **dadurch gekennzeichnet, dass** innerhalb oder ausserhalb der Energieversorgungsvorrichtung (3), gegebenenfalls Elemente einer Leiterbahn (23) überbrückende Schaltmittel (31) vorgesehen sind, mittels derer die Verbindung zwischen der Energiequelle (300) und der Leuchteinheit (1) wahlweise schliessbar oder unterbrechbar ist.

12. Leuchtvorrichtung (100) nach Anspruch 10 oder 11, **dadurch gekennzeichnet, dass** das Gehäuse (35) der Energieversorgungsvorrichtung (3) eine Öffnung (351) aufweist, in die das zugehörige Ende der Verbindungsvorrichtung (2) derart einsetzbar ist, dass die Kontakte (311, 312) der Energieversorgungsvorrichtung (3) an den Leiterbahnen (22, 23) anliegen und die Leuchteinheit (1) mit Strom versorgt wird.

13. Leuchtvorrichtung (100) nach einem der Ansprüche 1 bis 12, **dadurch gekennzeichnet, dass** die Leuchtvorrichtung sterilisiert und in einer lösbaren Schutzhülle (5) verpackt ist und/oder in eine dass die Leuchtvorrichtung ganz oder teilweise mit einer vorzugsweise transparenten Lage (6) beschichtet ist, die dem Schutz und/oder der Dekoration der Leuchtvorrichtung dient.

14. Leuchtvorrichtung (100) nach einem der Ansprüche 1 bis 13, **dadurch gekennzeichnet, dass** die Leuchteinheit (1), gegebenenfalls ein daran vorgesehenes thermisches Kontaktelement (12) direkt oder über eine Kontaktleitung (28) mit einer der Metallschichten (22, 23, 24) verbunden ist.

15. Leuchtvorrichtung (100) nach einem der Ansprüche 1 bis 14, **dadurch gekennzeichnet, dass** das Montageelement (4) mit einem Operationswerkzeug verbunden ist.
